Europäisches Patentamt

European Patent Office

Office européen des brevets

(11) Publication number: **0 474 954 A1**

# EUROPEAN PATENT APPLICATION

(21) Application number: **90830403.3**

(22) Date of filing: **14.09.90**

(51) Int. Cl.5: **H03F 3/30, H03F 3/45**

(43) Date of publication of application:
**18.03.92 Bulletin 92/12**

(84) Designated Contracting States:
**DE FR GB IT NL SE**

(71) Applicant: **SGS-THOMSON MICROELECTRONICS s.r.l.**
**Via C. Olivetti, 2**
**I-20041 Agrate Brianza Milano(IT)**

(72) Inventor: **Rossi, Domenico**
**Via Roma 161**
**I-27024 Cilavegna (Pavia)(IT)**
Inventor: **Cassis, Marco**
**Via Casluncio 60, Frazione S. Ambrogio**
**I-21100 Varese(IT)**
Inventor: **Monti, Marco**
**Via Martinetti 14/A**
**I-20147 Milan(IT)**

(74) Representative: **Modiano, Guido et al**
**MODIANO, JOSIF, PISANTY & STAUB**
**Modiano & Associati Via Meravigli, 16**
**I-20123 Milano(IT)**

(54) BICMOS driving stage for a class AB output gate in integrated circuits.

(57) The present invention relates to a BICMOS driving stage for a class AB output gate in integrated circuits which comprises an operational amplifier and an output gate. The operational amplifier is connected to the output gate by means of at least one N-channel transistor (24) the drain terminal whereof is connected to the gate terminal. The drain and gate terminals define an electric node to which the gate terminal of an N-channel transistor (27) is connected. The drain terminal of the N-channel transistor is connected to a node which is defined by the collector and base terminals of an NPN transistor (28) of the output gate.

Fig. 3

The present invention relates to a BICMOS driving stage for a class AB output gate in integrated circuits.

In purely bipolar circuits, one of the limitations, at least from the point of view of frequency behavior, is related to the low cutoff frequency of PNP lateral transistors. The cutoff frequency in PNP lateral transistors is in fact smaller by one or two orders of magnitude with respect to that of NPN bipolar transistors.

The described technical problem is currently usually overcome by using circuital techniques for the design of integrated circuits which are usually very complicated and prevent useful-signal paths across PNP transistors or by using vertical PNP insulated-collector transistors.

The latter components have a cutoff frequency which is comparable with that of NPN transistors, but in the process of execution of the integrated circuit they require two additional masks, with consequent increases in the cost and complexity of the production process.

The aim of the present invention is to eliminate or substantially reduce the disadvantages described above in known types of output stage by providing a BICMOS driving stage for a class AB output gate in integrated circuits which eliminates the problems of the low cutoff frequency caused by lateral PNP transistors.

Within the scope of the above described aim, an object of the present invention is to provide a BICMOS driving stage for a class AB output gate in integrated circuits which can be easily integrated.

Not least object of the present invention is to provide a BICMOS driving stage for a class AB output gate in integrated circuits which is relatively easy to execute and at competitive costs.

This aim, the objects mentioned and others which will become apparent hereinafter are achieved by a BICMOS driving stage for a class AB output gate in integrated circuits according to the invention, which comprises an operational amplifier and an output gate, characterized in that said operational amplifier is connected to said output gate by means of at least one N-channel transistor (24) the drain terminal whereof is electrically connected to the gate terminal, said drain and gate terminals defining an electric node to which the gate terminal of at least one N-channel transistor (27) is connected, the drain terminal of said N-channel transistor (27) being connected to a node defined by the collector and base terminals of an NPN transistor (28) of said output gate.

Further characteristics and advantages of the invention will become apparent from the description of a preferred but not exclusive embodiment of a BICMOS driving stage of a class AB output gate in integrated circuits according to the invention, illustrated only by way of non-limitative example in the accompanying drawings, wherein:

figure 1 is a diagram of a purely bipolar integrated circuit which comprises an operational amplifier and the related output stage according to the known art;

figure 2 is another diagram of a purely bipolar integrated circuit which comprises an operational amplifier and the related output stage according to the known art; and

figure 3 is a diagram of a BICMOS driving stage for a class AB output gate in integrated circuits according to the invention.

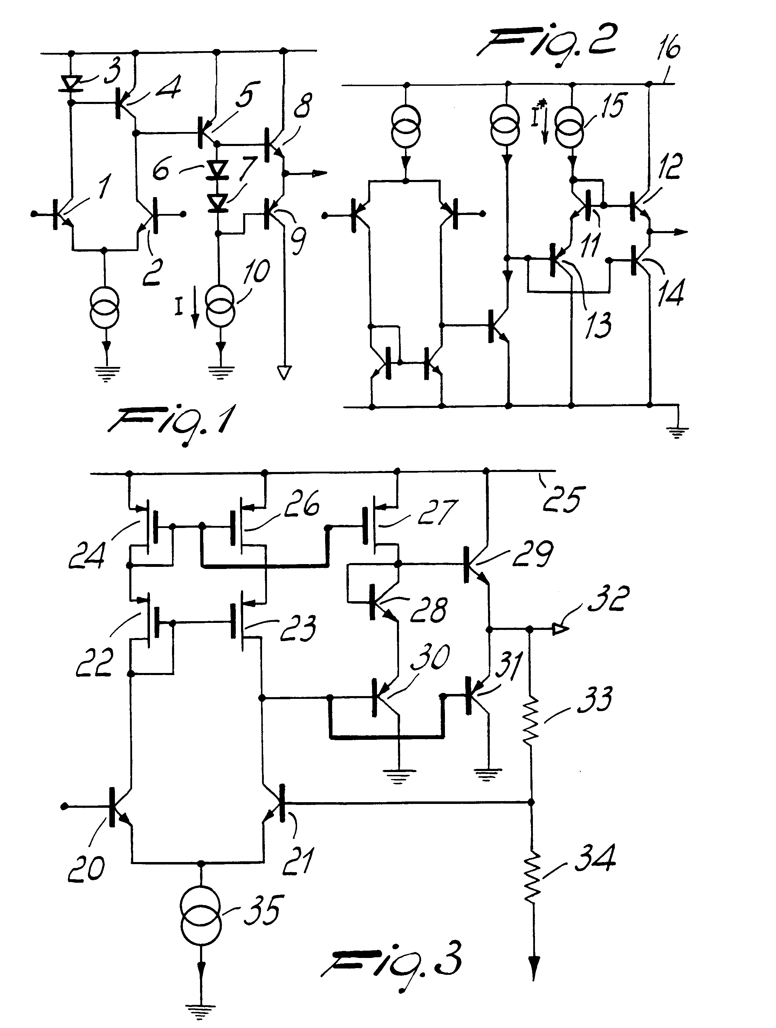

With reference to figure 1, which is a diagram of a known solution, an operational amplifier, composed of the NPN transistors 1 and 2 the respective base terminals whereof constitute input terminals for signals to be amplified, drives an output gate by means of a driving stage which is composed of an insulated-collector transistor 3 and of a PNP transistor 4 which is connected by means of its base terminal to a node defined by the cathode of the transistor 3 and by the collector terminal of the transistor 1 and is connected by means of the collector terminal to the collector terminal of the transistor 2 and to the base terminal of a PNP transistor 5.

The output gate comprises two insulated-collector transistors 6 and 7, an NPN transistor 8 and a PNP transistor 9. The anode of the transistor 6 is connected to the collector terminal of the transistor 5 and to the base terminal of the transistor 8, whereas the cathode of the transistor 6 is connected to the anode of the transistor 7. The cathode of the transistor 7 is connected to a source 10 of current I and to the base terminal of the transistor 9. The transistors 8 and 9 are mutually connected by means of the respective emitter terminals, and the node constituted by these last two terminals defines the output terminal of the output gate.

The bias current in the output gate is set by the current I and by the area ratio between the pairs of transistors 6, 8 and 7, 9. Since the transistor 7 is of the insulated-collector type, it is lateral, and the transistor 9 is consequently also lateral. The limitations of the output gate are therefore those which have been described above, i.e. problems related to the cutoff frequency, caused by the laterality of the PNP transistors; an asymmetrical behavior in the slew rate of the gate furthermore occurs.

The transistor 5 in fact amplifies the current which, multiplied by the gain $\beta_8$ of the transistor 8, provides a high output current, constituting an upward transition of the output, whereas multiplication by the gain of the transistor is unitary in the downward transitions of the output.

With reference to figure 2, which is a diagram of a known solution, said solution comprises an operational amplifier, whereas the output stage comprises an NPN transistor 11 which is diode-connected, i.e. with its collector terminal connected to the base terminal, to the node which is constituted by the connection between the collector terminal and the base terminal connected to the base terminal of an NPN transistor 12.

The emitter terminal of the transistor 11 is connected to the emitter terminal of a PNP transistor 13 the collector terminal whereof is connected to the ground. The emitter terminal of the transistor 12 is connected to the emitter terminal of a PNP transistor 14 the collector terminal whereof is connected to the ground. The output of the output gate constituted by the transistors 12 and 14 is connected to the node formed by the two emitter terminals.

The base terminals of the transistors 13 and 14 are connected together to the output of the operational amplifier. A source 15 of current I* is connected between the power supply 16 and the collector and base terminals of the transistor 11 and drives the described output stage. This execution provides the output stage with vertical non-insulated PNP transistors and is possible only with PNP transistors at the input. Otherwise it is necessary to introduce a further amplifier stage. The same problems discussed above from the point of view of the slew rate of the output occur with this last solution.

The art currently allows to execute, without using further masks, PNP transistors with the collector terminal not insulated but connected to the ground which have a good frequency response and a high current gain. Said transistors can be used to produce class AB output stages which have a large bandwidth and which in any case do not limit the operational amplifier in terms of band. They furthermore have a good current response with respect to the corresponding lateral transistors.

With reference to figure 3, a BICMOS driving stage for a class AB output gate in integrated circuits according to the invention comprises an operational amplifier constituted by a first NPN transistor 20 and by a second NPN transistor 21 the respective emitter terminals whereof are connected to one another and connected to a current source 35 which is connected to the ground, whereas the respective base terminals constitute input terminals for the operational amplifier.

The collector terminal of the first transistor 20 is connected to the drain and gate terminals of a third N-channel transistor 22. The gate and drain terminals of the third transistor 22 are furthermore connected to the gate terminal of a fourth N-channel transistor 23. The drain terminal of the fourth transistor 23 is connected to the collector terminal of the second transistor 21.

The source terminal of the third transistor 22 is connected to the drain and gate terminals of a fifth N-channel transistor 24. The source terminal of the fifth transistor 24 is connected to a power supply 25 of the driving stage. The gate terminal of a sixth transistor 26 is connected to the drain and gate terminals of the fifth transistor 24 and the source terminal of the sixth transistor 26 is connected to the power supply 25.

The drain and gate terminals of the fifth transistor 24 and the gate terminal of the sixth transistor 26 are furthermore connected to the gate terminal of a seventh N-channel transistor 27. The drain terminal of the sixth transistor 26 is connected to the source terminal of the fourth transistor 23.

The seventh transistor 27 has its source terminal connected to the power supply 25 and its drain terminal connected to the collector and base terminals of an eighth NPN transistor 28.

A ninth NPN transistor 29 has its base terminal connected to the node defined by the collector terminal of the eighth transistor 28 and by the drain terminal of the seventh transistor 27, and its collector terminal is connected to the power supply 25.

The base terminal of a tenth PNP transistor 30 is connected to the node defined by the drain terminal of the fourth transistor 23 and by the collector terminal of the second transistor 21. The tenth transistor 30 furthermore has its emitter terminal connected to the emitter terminal of the eighth transistor 28 and its collector terminal connected to the ground.

An eleventh PNP transistor 31 has its base terminal connected to the base terminal of the tenth transistor 30 and its emitter terminal connected to the emitter terminal of the ninth transistor 29; finally, its collector terminal is connected to the ground.

The node defined by the emitter terminals of the ninth transistor 29 and of the eleventh transistor 31 comprises an output terminal 32 from the output gate. The output signal present on the output terminal 32 can be negatively feedback by means of a divider which comprises a pair of resistors 33 and 34 and is arranged in input to the base terminal of the second transistor 21.

The output gate, i.e. the connection between the base and collector terminals of the eighth transistor 28 and the base terminal of the ninth transistor 29, is driven by the seventh transistor 27 which, for all purposes, has a current which depends on the differential input signal.

The direct-current biasing of the output gate is instead set by the ratio W/L between the sixth transistor 26 and the seventh transistor 27, where W and L are the transverse and longitudinal dimensions of each N-channel transistor, and by the area ratio between the pairs of transistors 28/29 and 30/31. In detail, the current is divided equally between the tenth transistor 30 and the eleventh transistor 31, and therefore the drain current $I_{D24}$ of the fifth transistor 24 and the drain current $I_{D26}$ of the sixth transistor 26 have the following relation:

$I_{D24} = I_{D26}$

only if

$W/L26 = W/L24$

Assuming that the following is true:

$W/L26 = W/L27$

the drain current $I_{D27}$ of the seventh transistor 27 is equal to the collector current $I_{C28}$ of the eighth transistor 28 and is furthermore equal to the current $I_{30}$ which flows across the tenth transistor 30, i.e., in symbols,

$I_{D27} = I_{C28} = I_{30}$

This current is then mirrored by the pairs of transistors 28, 29 and 30, 31. The current $I_{D27}$ in any case depends on the imbalance between the transistors 20 and 21.

The N-channel transistors 22, 23, 24, 26 and 27 have been introduced since despite being crossed by a signal path they do not limit the frequency bandwidth of the operational amplifier to a great extent.

As regards the behavior of the slew rate of the output, since the current which drives on the base terminal the ninth transistor 29 and the tenth transistor 30 is differential in both directions, i.e. both in the positive direction and in the negative direction, the slew rate of the output is symmetrical.

There is also the advantage of keeping a single amplifier stage in input to NPN transistors, i.e. a wide input frequency band is maintained, and the class AB output gate furthermore has insulated vertical PNP and NPN transistors, with the above described advantages.

The invention thus conceived is susceptible to numerous modifications and variations, all of which are within the scope of the inventive concept. For example, the N-channel transistors 22, 23, 24, 26 and 27 may be replaced with PNP bipolar transistors, but the bandwidth of the output gate is reduced.

All the details may furthermore be replaced with other technically equivalent elements.

In practice, the materials employed, as well as the dimensions, may be any according to the requirements.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. BICMOS driving stage for a class AB output gate in integrated circuits which comprises an operational amplifier and an output gate, characterized in that said operational amplifier is connected to said output gate by means of at least one N-channel MOS transistor (24) the drain terminal whereof is electrically connected to the gate terminal, said drain and gate terminals defining an electric node to which the gate terminal of at least one N-channel transistor (27) is connected, the drain terminal of said N-channel transistor (27) being connected to a node which is defined by the collector and base terminals of an NPN transistor (28) of said output gate.

2. BICMOS driving stage, according to claim 1, characterized in that said operational amplifier comprises a first NPN transistor (20) and a second NPN transistor (21) the base terminals whereof constitute input terminals for said operational amplifier, the emitter terminals of said first and second transistors being connected to one another, a current source (35) being connected to the node defined by said emitter terminals and to the ground, the collector terminal of said first transistor being connected to the drain and gate terminals of a third N-channel transistor (22) the gate and drain terminals whereof are furthermore connected to the gate terminal of a fourth N-channel transistor (23) the drain terminal whereof is connected to the collector terminal of said second transistor.

3. BICMOS driving stage, according to claim 2, characterized in that the source terminal of said third transistor is connected to the drain and gate terminals of a fifth N-channel transistor (24) the source terminal whereof is connected to a power supply of said driving stage, the gate terminal of a sixth transistor (26) being connected to the drain and gate terminals of said fifth transistor, the source terminal of said sixth transistor being connected to said power supply, the drain and gate terminals of said fifth transistor and the gate terminal of said sixth transistor being connected to the gate terminal of a seventh N-channel transistor (27), the drain terminal of said sixth transistor being connected to the source terminal of said fourth transistor.

4. BICMOS driving stage, according to claim 3, characterized in that said seventh transistor has its source terminal connected to said power supply and its drain terminal connected to the collector and base terminals of an eighth NPN transistor (28), a ninth NPN transistor (29) having its base terminal connected to the node defined by the collector terminal of said eighth transistor and by the drain terminal of said seventh transistor and having its collector terminal connected to said power supply.

5. BICMOS driving stage, according to claim 4, characterized in that it comprises a tenth PNP transistor (30) the base terminal whereof is connected to the node defined by the drain terminal of said fourth transistor and by the collector terminal of said second transistor, the emitter terminal being connected to the emitter terminal of said eighth transistor and the collector terminal connected to the ground.

6. BICMOS driving stage, according to claim 5, characterized in that it comprises an eleventh PNP transistor (31) the base terminal whereof is connected to the base terminal of said tenth transistor, the emitter terminal being connected to the emitter terminal of said ninth transistor and the collector transistor being connected to the ground.

7. BICMOS driving stage, according to claim 6, characterized in that the node defined by the emitter terminals of said ninth and eleventh transistors comprises an output terminal from said output gate.

8. BICMOS driving stage, according to one or more of the preceding claims, characterized in that the output signal which is present on said output terminal can be negatively fedback by means of a divider which comprises a pair of resistors (33, 34) and is arranged in input to the base terminal of said second transistor.

9. BICMOS driving stage, according to one or more of the preceding claims, characterized in that said third, fourth, fifth, sixth and seventh transistors are PNP bipolar transistors.

Fig.2

Fig.1

Fig.3

European
Patent Office

EUROPEAN SEARCH
REPORT

Application Number

EP 90 83 0403

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | 1989 IEEE INTERNATIONAL SYMPOSIUM ON CIRCUITS AND SYSTEMS vol 2 of 3 , May 8-11, 1989, Portland, OR. R.E. Vallee et al. :"High Performance CMOS Operational-Amplifier" pages 1475-1478. * Page 1476 right-hand column,lines 20-40, figur e 3a * | 1,3,4 | H 03 F 3/30 H 03 F 3/45 |
| A | US-A-4 935 703   (VANNI POLETTO) * column 2, line 21 - column 4, line 41; figures 1-2b * | 2,4-7,9 | |
| A | US-A-3 644 838   (STEFANO GRAF) * column 2, line 26 - column 7, line 55; figure 1 * | 1-6 | |
| A | TELECOMMUNICATIONS AND RADIO ENGINEERING. vol. 41/42, no. 10, October 1987, WASHINGTON US pages 132 - 136; V.Ya. Groshev: "Methods of Increasing the Relative Speed of Operational Amplifiers" * page 134, line 14 - page 136, line 8; figure 3 * | 1,2,4-7 | |
| A | IEEE JOURNAL OF SOLID-STATE CIRCUITS. vol. 24, no. 1, February 1989, NEW YORK US pages 189 - 193; D.J.F. Doyle et al: "Circuit Modeling of Bipolar Transistors for BiCMOS" * page 192, left-hand column, line 32 right-hand column, line 2; figure 5 * | 1-8 | TECHNICAL FIELDS SEARCHED (Int. Cl.5)  H 03 F |

The present search report has been drawn up for all claims

| Place of search | Date of completion of search | Examiner |
|---|---|---|
| The Hague | 17 May 91 | TYBERGHIEN G.M.P. |